# EUROPÄISCHE PATENTSCHRIFT

(11) **EP 2 521 804 B1**
(45) Veröffentlichungstag und Bekanntmachung des Hinweises auf die Patenterteilung: **20.04.2016**
(21) Anmeldenummer: 10816355.1
(22) Anmeldetag: 20.12.2010
(51) Int. Cl.: C23C 16/517, C23C 16/54, H01J 37/32

(54) **INLINE-BESCHICHTUNGSANLAGE**
INLINE COATING INSTALLATION
INSTALLATION DE REVÊTEMENT EN LIGNE

(30) Priorität: 04.01.2010 DE 102010000001
(43) Veröffentlichungstag der Anmeldung: 14.11.2012
(73) Patentinhaber: Meyer Burger (Germany) AG, 09337 Hohenstein-Ernstthal (DE)
(72) Erfinder: MAI, Joachim, 04603 Nobitz (DE); SCHLEMM, Hermann, 07743 Jena (DE); GROSSE, Thomas, 08371 Glauchau (DE); DECKER, Daniel, 09427 Ehrenfriedersdorf (DE); GRIMM, Michael, 09116 Chemnitz (DE)
(74) Vertreter: Steiniger, Carmen
(86) Internationale Anmeldenummer: PCT/IB2010/055949
(87) Internationale Veröffentlichungsnummer: WO 2011/080659

(56) Entgegenhaltungen:
- EP-A1- 2 298 956
- DE-A1- 19 634 795
- US-A- 5 589 007
- US-A1- 2004 112 537
- US-A1- 2006 199 014
- US-A1- 2008 102 222

## Beschreibung

Die Erfindung betrifft eine Inline-Beschichtungsanlage zur plasmagestützten chemischen Gasphasenabscheidung, die wenigstens eine Prozesskammer mit wenigstens zwei nacheinander in Förderrichtung von Substraten durch die Prozesskammer angeordneten Plasmaquellen aufweist.

Anlagen der oben genannten Gattung werden bereits seit geraumer Zeit beispielsweise in der Mikroelektronik zur Beschichtung von Substraten verwendet. Dabei durchlaufen die Substrate die Prozesskammer und passieren dabei die einzelnen Plasmaquellen, die jeweils so ausgebildet und eingestellt sind, dass auf die Substrate gleiche, homogene Schichten mit gleichbleibender Qualität und Eigenschaften abgeschieden werden.

Darüber hinaus sind im Stand der Technik auch Anlagen zur Abscheidung von Mehrlagenschichten und Inline-Anlagen zur großflächigen Abscheidung von Mehrlagenschichten auf Substraten bekannt. Die bisher verwendete Anlagentechnik wurde für verschiedene Anwendungsbereiche in sehr unterschiedliche, spezialisierte Richtungen entwickelt. Es gibt beispielsweise hochflexible Labor-Beschichtungsanlagen für Forschungszwecke, Anlagen mit hochspezialisierten Beschichtungsmodulen für die Mikroelektronik, Anlagen zur Beschichtung von Kunststofflinsen und Brillengläsern und spezielle Anlagen zur großflächigen Beschichtung von Architekturglasplatten, Folien oder auch Solarzellen. Hierbei werden einzelne dünne Schichten oder auch Mehrlagenschichten zur Verbesserung der Wärmedämmung, Reflexionssteigerung bzw. Reflexionsminderung oder zur auch zur Passivierung von Oberflächen eingesetzt.

Für die produktive Herstellung von Mehrlagenschichten wird entweder für jede Schicht eine getrennte Prozesskammer verwendet oder die Schichten werden in einem diskontinuierlichen Batchverfahren nacheinander in einer Prozesskammer, das heißt in einer zeitlichen Abfolge von verschiedenen Beschichtungsprozessen, auf die Substrate aufgebracht.

Werden Inline-Plasmabeschichtungsanlagen mit mehreren Prozesskammern eingesetzt, so können nacheinander unterschiedliche Schichten mit verschiedenen Schichteigenschaften abgeschieden werden. In jeder einzelnen Prozesskammer werden bestimmte Gase und Gasmischungen sowie gleiche Plasmaquellen mit bestimmten elektrischen Betriebsbedingungen eingesetzt. Jede Einzelschicht benötigt dabei eine eigens dafür optimierte Prozesskammer mit optimierten Prozessbedingungen. Zur Vermeidung der Verschleppung von Prozessgasen werden zwischen den einzelnen Prozesskammern Trennkammern mit eigenen Pumpsystemen und Vakuumventilen zur Vakuumabtrennung verwendet. Nachteilig dabei ist, dass dann zwischen den einzelnen Prozesskammern kein kontinuierlicher Transport der Substrate möglich ist. Die Substrate müssen in der Trennkammer solange warten, bis die notwendige Sauberkeit zum Transport in die folgende Prozesskammer erreicht ist. Bei Mehrlagenschichten aus Einzelschichten, die zueinander nur geringe Änderungen in den Schichtzusammensetzungen aufweisen müssen, ist eine solche Verfahrensweise aber zeitaufwändig und verringert den möglichen Substratdurchsatz. Weiterhin können durch die notwendigen Prozessunterbrechungen zwischen den einzelnen Prozesskammern auch zusätzliche Verunreinigungen auf die schon beschichteten Substrate gelangen und die Schichten können sich, z.B. durch das Vorhandensein von reaktiven und freien Bindungen in der Schicht bzw. an der Oberfläche der Einzelschicht, bevor sie schließlich in der folgenden Prozesskammer weiterprozessiert werden, verändern. Gradientenschichten sind mit diesen bekannten Anlagenkonzept nicht oder nur schwierig herstellbar.

Zur Herstellung von Mehrlagenschichten in CVD-Anlagen werden die Einzelschichten zum Beispiel durch unterschiedliche Gase, unterschiedliche Gasgemische oder andere geeignete unterschiedliche Parameter hergestellt. In Anlagen zur physikalischen Gasphasenabscheidung (PVD-Anlagen) können bei Einsatz des gleichen Vakuums oder des gleichen Zerstäubungsgases Schichten aus unterschiedlichen Materialien hergestellt werden. Daher ist es bei PVD-Anlagen einfacher möglich, mehrere Schichten in einer Kammer herzustellen. So ist beispielsweise in der Druckschrift G 94 07 482.8 eine derartige PVD-Anlage beschrieben, in welcher mehrere Sputterkathoden in einer Prozesskammer angeordnet sind.

CVD-Anlagen verwenden zur Schichtherstellung flüssige oder gasförmige Ausgangsstoffe, die chemische Verbindungen des abzuscheidenden Schichtmaterials sind. Für die Bereitstellung der chemischen Verbindungen sind vielfach bestimmte Besonderheiten zu beachten. Eine CVD-Anlage zur Herstellung einer bestimmten Schicht wird deshalb oft speziell geplant und ausgeführt. Eine flexible Verwendung einer CVD-Anlage zur Herstellung von Mehrlagenschichten ist im Allgemeinen technisch aufwändig.

Beispielsweise beschreibt die Druckschrift WO 2007/051457 A2 eine Inline-Anlage zur Herstellung einer zweilagigen Antireflexionsbeschichtung auf Silizium-Solarzellen. Dabei wird üblicherweise für die Herstellung jeder Teilschicht eine separate Kammer verwendet. Es ist allerdings auch ein mögliches Ausführungsbeispiel genannt, in dem in einer Kammer eine erste Teilschicht mit einer plasmaunterstützten CVD-Technik abgeschieden und eine zweite Teilschicht in einem weiteren Teil der Vakuumkammer durch ein Sputterverfahren (PVD) hergestellt wird. Eine Kombination einer Sputterabscheidung und einer CVD-Abscheidung In einer Kammer ist aber ungünstig, da unterschiedliche Arbeitsgase für die CVD- und die PVD-Abscheidung benötigt werden und das Arbeitsgas der CVD-Abscheidung vor der PVD-Abscheidung vollständig abgepumpt werden muss, was zeit- und kostenaufwändig ist. PVD-Schichten haben auch einige prinzipielle Nachteile gegenüber CVD-Schichten, beispielsweise kann es bei strukturierten Substraten oder bei Partikeln auf dem Substrat durch Abschattungen zu ungenügenden Beschichtungen kommen.

Die Druckschrift US 2004/0112537 A1 offenbart Inline-Anlagen zur Plasmabearbeitung von Glasscheiben zur Flachbildschirmherstellung. Hierfür werden Plasmaquellen eingesetzt, die bei einer Frequenz zwischen 10 MHz und 500 MHz arbeiten. In einer Ausführungsform sind in einer Prozesskammer mehrere Plasmaquellen nacheinander angeordnet, wobei jede der Plasmaquellen über eine eigene HF-Leistungsquelle verfügt. Mit einer solchen Anlage kann beispielsweise ein Schichtstapel von 50 nm Siliziumoxid und 100 nm Siliziumnitrid kontinuierlich abgeschieden werden. Die unterschiedlichen Schichten werden dabei dadurch erzeugt, dass die einzelnen Plasmaquellen mit unterschiedlichen Gasen versorgt werden.

Aus der Druckschrift US 2008/0102222 A1 sind kontinuierlich arbeitende Plasmaanlagen bekannt, wobei das Plasma ein induktiv gekoppeltes Plasma ist. Die verwendeten Substrate sind typischerweise Folien, die von Rolle zu Rolle während der Auflage auf einer Trommel beschichtet werden. Dabei können in die Trommel mehrere Plasmaquellen angeordnet werden. Die mehreren Plasmaquellen können dafür eingesetzt werden, Mehrlagenschichten abzuscheiden oder eine größere Abscheidegeschwindigkeit zu erzielen. Die verwendeten Plasmaquellen können mehrere Spulen aufweisen, die über eigene HF-Generatoren verfügen können. Dabei können zur Vermeidung von Indifferenzen voneinander differierende HF-Frequenzen eingesetzt werden. Zur Herstellung unterschiedlicher Schichten werden unterschiedliche Typen oder Mengen von Gasen eingesetzt.

Die Druckschrift DE 196 34 795 A1 beschreibt Plasma-CVD-Anlagen, bei denen Mikrowellen-Plasmaelektroden zu einem Array zusammengeschaltet sind, wobei in dem Array die benachbarten Plasmaelektroden zu verschiedenen Zeiten mit unterschiedlichen Mikrowellenimpulsen beaufschlagt werden. Durch den abwechselnden Impulsbetrieb benachbarter Plasmaelektroden werden Indifferenzen vermieden. Ferner ist in der Druckschrift erläutert, dass bei einer Plasmaquelle zusätzlich zu der Mikrowellenanregung eine Radiofrequenz-Anregung zum Einsatz kommen kann, um die Schichthomogenität zu verbessern.

In der Druckschrift US 5,589,007 A werden Anlagen zur Rolle-zu-Rolle-Beschichtung von Folien zur Herstellung von Solarzellen vorgestellt. Dabei werden in einer Anlage sowohl HF-PECVD-Kammern als auch Mikrowellenkammem eingesetzt, die jeweils voneinander isoliert sind und aneinander angereiht sind, um umfangreiche Schichtstapel zur Ausbildung von Tandemsolarzellen abzuscheiden.

Die Druckschrift US 2006/0199014 A1 offenbart eine Plasmavorrichtung zur Abscheidung von Dünnschichten auf Substraten, wobei die Plasmavorrichtung eine als Substratträger ausgebildete, horizontal durch die Plasmavorrichtung bewegbare Elektrode sowie zwei oberhalb der Substratträgerelektrode In Substrattransportrichtung des Substrates nacheinander angeordnete Elektroden aufweist. Durch Wechselwirken der Substratträgerelektrode zunächst mit der ersten Elektrode und anschließend mit der zweiten Elektrode werden zwei Schichten auf dem Substrat ausgebildet, wobei die Elektroden mit unterschiedlichen Frequenzen betreibbar sind.

Es ist die Aufgabe der vorliegenden Erfindung, eine Inline-Beschichtungsanlage der oben genannten Gattung bereit zu stellen, die eine kontinuierliche, großflächige und effektive Abscheidung von hochqualitativen Mehrlagen- und/oder Gradientenschichten ermöglicht.

Die Aufgabe wird erfindungsgemäß durch eine Inline-Beschichtungsanlage nach Patentanspruch 1 gelöst. Besondere Ausführungsarben der Erfindung sind in Patentansprüchen 2-14 angegeben.

In einer Prozesskammer können wichtige Prozessparameter für die Abscheidung nur insgesamt für die gesamte Kammer eingestellt werden, das sind beispielsweise der Druck und mit Grenzen auch die Temperatur und die Gaszusammensetzung. Durch die Verwendung von unterschiedlichen Plasmaquellen mit unterschiedlichen Plasmaparametern ist es jedoch mit der erfindungsgemäßen Inline-Beschichtungsanlage möglich, bei den in der Kammer herrschenden Bedingungen gleichzeitig mehrere verschiedene Schichten oder Schichten mit sich mit deren Dicke ändernden Schichteigenschaften, d.h. Gradientenschichten abzuscheiden. Dabei werden erfindungsgemäß die Plasmaquellen entsprechend der gewünschten Schichtreihenfolge und/oder Schichteigenschaften ausgewählt und in der Anlage angeordnet.

Für eine Beschichtung besteht oft eine lange Forderungsliste, wobei die Forderungen oft widersprüchlich sind. Beispielsweise steht oft die Anforderung an eine hohe Beschichtungsrate im Widerspruch mit der Anforderung an eine hohe Schichtqualität. Bei der Herstellung nur einer Schicht muss auf diesen Widerspruch mit einem Kompromiss geantwortet werden. Bei einer Herstellung mehrerer dünner Schichten statt einer dicken Schicht können die einzelnen Forderungen der Forderungsliste auf die einzelnen Schichten verteilt werden, und die Forderungsliste an die Beschichtung kann insgesamt durch mehrere Teilschichten besser befriedigt werden. Zur Erfüllung der Forderungsliste an die Beschichtung ist es oft möglich, Mehrlagenschichten aus Einzelschichten abzuscheiden, die zueinander nur eine geringe Änderung aufweisen. Diese geringen Änderungen können beispielsweise in der Schichtzusammensetzung, der Stöchiometrie, der Dichte, der Reinheit oder der Rauheit bestehen. Die Erfindung löst die Aufgabe der Herstellung mehrerer sich nur geringfügig unterscheidender Schichten durch eine besondere Anordnung unterschiedlicher Plasmaquellen in einer einzigen Prozesskammer und durch einen geeigneten unterschiedlichen Betrieb der unterschiedlichen Plasmaquellen.

Erfindungsgemäß unterscheiden sich die zwei unterschiedlichen Plasmaquellen durch ihre unterschiedlichen Betriebsfrequenzen. Unterschiedliche Plasmafrequenzen haben einen erheblichen Einfluss auf die Energieverteilung der Ladungsträger im Plasma, auf die Bildung von Radikalen und letztlich auf die Eigenschaften der mit dem Plasma hergestellten Schichten.

In einer vorteilhaften Ausbildung der vorliegenden Erfindung ist wenigstens eine der wenigstens zwei Plasmaquellen eine mit gepulster Anregungsfrequenz betriebene Plasmaquelle. Durch unterschiedliche Pulsparameter der Plasmaquellen können die Eigenschaften von hergestellten Schichten erheblich beeinflusst werden. Beispielsweise können unterschiedliche Pulsfrequenzen, Peakleistungen und/oder unterschiedliche Einschaltdauern der Pulse an die jeweilige Plasmaquelle angelegt werden. Damit eignet sich diese Ausführungsform insbesondere zur Herstellung von Mehrlagen- und/oder Gradientenschichten.

In der erfindungsgemäßen Inline-Beschichtungsanlage werden wenigstens zwei Plasmaquellen verwendet, wobei wenigstens eine erste Plasmaquelle bei niedriger Frequenz, das heißt, zwischen Gleichstrom und 100 MHz, arbeitet und wenigstens eine zweite Plasmaquelle zwischen 100 MHz und einigen GHz, also im Mikrowellenbereich, arbeitet. Die Plasmaquelle mit niedriger Frequenz kann Ionen mit einer hohen kinetischen Energie von bis zu 200 eV erzeugen. Diese Ionen können zum Beispiel dazu benutzt werden, eine hohe Haftfestigkeit von Schichten auf dem Substrat zu erreichen oder Schichten mit einer hohen Dichte abzuscheiden. Die Stärken der Mikrowellenplasmaabscheidung liegen hingegen in einer effektiven Precursoraktivierung verbunden mit hohen Abscheideraten. Die Mikrowellenplasmaquellen eignen sich daher besonders gut zur Herstellung haftfester dicker Schichten und zur Erfüllung von Durchsatzanforderungen.

In einer besonders bevorzugten Ausbildung der erfindungsgemäßen Inline-Beschichtungsanlage arbeitet die erste Plasmaquelle in einem Bereich von 50 kHz bis 13,56 MHz, und die zweite Plasmaquelle ist eine in einem Bereich von 915 MHz bis 2,45 GHz arbeitende Plasmaquelle. In diesen Frequenzbereichen existieren ausgereifte, kommerziell verfügbare Plasmaquellen, sodass die erfindungsgemäße Inline-Beschichtungsanlage mit hoher Qualität zur Verfügung gestellt werden kann.

Gemäß einer günstigen Variante der erfindungsgemäßen Inline-Beschichtungsanlage ist die wenigstens eine erste Plasmaquelle, die bei einer geringen Frequenz arbeitet, in der Förderrichtung der Substrate durch die Prozesskammer vor der wenigstens einen zweiten Plasmaquelle, die bei der höheren Frequenz arbeitet, angeordnet. Für die Abscheidung von hochwertigen Schichten ist es oft günstig, zunächst eine Anfangsbeschichtung herzustellen, wobei durch hohe lonenenergien eine gute Haftung bzw. eine hohe Schichtdichte hergestellt wird. Im weiteren Verlauf der Beschichtung sind die hohen lonenenergien nicht mehr erforderlich, hingegen ist aus Kostengründen das schnelle Erreichen der gewünschten Schichtdicke bzw. eine hohe Abscheiderate wichtig.

In der erfindungsgemäßen Inline-Beschichtungsanlage ist die wenigstens eine erste, niederfrequente Plasmaquelle eine RF-Plasmaquelle oder eine ICP-Plasmaquelle und die wenigstens eine zweite, höherfrequente Plasmaquelle eine Mikrowellen-Plasmaquelle. Diese im Megahertzbereich arbeitenden RF- und ICP-Plasmaquellen haben sich in der Praxis gut bewährt. Die Auswahl der konkreten Frequenzen hängt natürlich wesentlich davon ab, welche Frequenzen gesetzlich für technische Zwecke freigegeben sind. Bei einer Änderung der Gesetzeslage könnten auch andere Frequenzen als die heute üblichen verwendet werden.

In einer bevorzugten Ausführungsform der erfindungsgemäßen Inline-Beschichtungsanlage weisen die wenigstens zwei unterschiedlichen Plasmaquellen linear skalierbare Plasmaquellen auf. Durch die lineare Skalierbarkeit können Anlagen unterschiedlich breit gebaut werden, wobei sich die Breite an der von den Kunden bevorzugten Substratbreite orientiert. Durch die lineare Skalierbarkeit ändert sich die Plasmaquelle nur in der Breite quer zur Transportrichtung des Substrates. In der Transportrichtung der Substrate sind die linear skalierbaren Plasmaquellen hingegen gleich dimensioniert und werden gleich betrieben. Dadurch können Anlagen für verschiedene Substratbreiten in Transportrichtung der Substrate in einer analogen Weise ausgebildet werden und es können analoge Beschichtungsprozesse verwendet werden.

In einer günstigen Ausbildung der erfindungsgemäßen Inline-Beschichtungsanlage sind die Plasmaquellen Punktquellen oder kreissymmetrische Quellen, die in einer linearen Anordnung zusammengefasst sind, wobei der Abstand zwischen diesen Plasmaquellen so gewählt ist, das sich deren einzelne Plasmen an den Oberflächen der Substrate zu einem gemeinsamen Plasma überlagern. Eine Mehrzahl von Punktquellen oder kreissymetrischen Quellen wird also zu einer linearen Quelle zusammengefasst. Durch die Beschränkung der Quellenkonstruktion auf einen Punkt ist eine besonders einfache Konstruktion möglich. Mit solchen Punktquellen ist eine lineare Skalierung einfach durch Auswahl der richtigen Zahl von Punktquellen zu realisieren.

In einer optionalen Weiterbildung der erfindungsgemäßen Inline-Beschichtungsanlage sind wenigstens zwei der Plasmaquellen zu wenigstens einer Gruppe von Plasmaquellen zusammengefasst. Durch die Zusammenfassung zu Gruppen kann aus einheitlichen Grundelementen von Plasmaquellen eine große Plasmaquellengruppe ausgebildet werden, wobei die Gruppe von Plasmaquellen wie eine große Plasmaquelle wirkt. Eine Zusammenstellung von gleichen Grundelementen zu einem großen Element ist in der Konstruktion viel einfacher zu realisieren als eine Neukonstruktion einer großen Plasmaquelle in der gerade benötigten Größe. Außerdem ist es für die Wartung günstig, wenn Ersatzteile nur für einen Plasmaquellentyp vorrätig gehalten werden müssen.

Gemäß einer weiteren Option der erfindungsgemäßen Inline-Beschichtungsanlage weisen die wenigstens zwei Plasmaquellen und/oder Gruppen von Plasmaquellen separate Gaszuführungen auf. Die Prozessgase vermischen sich zwar in der einen Prozesskammer, aber zwischen Gaseinlass und Gasauslass können durchaus erhebliche Gradienten in der Gaszusammensetzung auftreten. Für zwei Plasmaquellen können so durch separate Gasversorgungen auch in einer Kammer in Grenzen unterschiedliche Gaszusammensetzungen bereitgestellt werden. Durch die separaten Gasversorgungen ist eine größere Variation von Schichteigenschaften möglich als mit einer gemeinsamen Gasversorgung. Es ist auch möglich, in eine Plasmaquelle ein komplett anderes Gas einzuspeisen. Dadurch wird eine noch größere Variationsbreite der Schichteigenschaften erreicht. Je nach Überlappung der Plasmen und Gase ist es auch möglich, die Schichteigenschaften mehr oder weniger stark ineinander überfließen zu lassen und sogenannte Gradientenschichten herzustellen.

In einer besonders günstigen Variante der erfindungsgemäßen Inline-Beschichtungsanlage wird jede der wenigstens zwei verschiedenen Plasmaquellen und/oder Gruppen von Plasmaquellen mit einer separaten Gasabsaugung versehen. Durch die separaten Gasabsaugungen wird eine weitere Separierung der Beschichtungsbereiche vor den wenigstens zwei Plasmaquellen erreicht. Dadurch ist auch eine weitere Aufspreizung der Schichteigenschaften der hergestellten Schichten möglich.

Es hat sich zudem als vorteilhaft erwiesen, wenn die separate Gasabsaugung einen Raum aufweist, in welchen ein entstehender Abgasstrom beidseitig an jeder Seite der Plasmaquellen absaugbar ist. Für eine gleichmäßige Beschichtung der Substrate ist es erforderlich, dass an jedem Ort der Beschichtung die gleichen Bedingungen herrschen. Unter anderem ist es auch erforderlich, dass die Absaugung der verbrauchten Gase an jedem Ort gleichmäßig erfolgt. Für eine gute Entkopplung zwischen Pumpanschluss und Prozesskammer ist es günstig, durch den zusätzlichen Raum in der Gasabsaugung eine Entkopplung einzubauen. Durch den beidseitigen Abgasstrom an jeder einzelnen der Plasmaquellen wird eine besonders gleichmäßige Abgasabführung realisiert, überdies werden durch die beidseitige Abgasableitung die Plasmaquellen auch von benachbarten Plasmaquellen besser entkoppelt.

In einer weiteren möglichen Ausbildung der erfindungsgemäßen Inline-Beschichtungsanlage sind zwischen den einzelnen Plasmaquellen und/oder Gruppen von Plasmaquellen Leitwertblenden angeordnet. Durch die Leitwertblenden werden die Plasmaquellen zusätzlich voneinander isoliert, so dass eine weitere Abgrenzung der Reaktionsräume voneinander möglich ist.

Es ist ferner von Vorteil, wenn die erfindungsgemäße Inline-Beschichtungsanlage ein Transportsystem für die Substrate mit wenigstens einem Steuermodul für die Transportgeschwindigkeit und/oder Transportrichtung der Substrate aufweist. Im einfachsten Fall werden Substrate mit einer gleichmäßigen Geschwindigkeit in Transportrichtung durch die Inline-Beschichtungsanlage transportiert. In der genannten Weiterbildung ist es jedoch auch möglich, die Transportgeschwindigkeit der Substrate lokal zu reduzieren, um beispielsweise unter einer Plasmaquelle eine längere Beschichtung zu erreichen. Desweiteren ist es möglich, auch die Transportrichtung der Substrate bei der Beschichtung zu ändern. Durch eine Änderung der Transportrichtung kann eine räumliche Substratoszillation ausgeführt werden, welche beispielsweise für eine Erhöhung der Schichthomogenität sinnvoll sein kann; es sind aber auch andere Anwendungen wie beispielsweise die mehrfache Beschichtung durch eine Abfolge verschiedener Plasmaquellen möglich, wodurch die Ausbildung von Vielfachschichten erreicht werden kann.

In einer günstigen Weiterbildung der erfindungsgemäßen Inline-Beschichtungsanlage weist die Beschichtungsanlage wenigstens eine Heiz- und/oder Kühlvorrichtung auf, wobei die Substrate und/oder Substratträger in Abhängigkeit von ihrer Position in der Inline-Beschichtungsanlage verschieden beheizbar und/oder kühlbar sind. Die Substrattemperatur ist ein Beschichtungsparameter, der Einfluss auf die Schichteigenschaften hat. Durch die Verwendung von Heiz- oder Kühlvorrichtungen ist ein Einfluss auf die Substrattemperatur innerhalb der Inline-Beschichtungsanlage möglich. Damit können die Substrattemperaturen für jede Plasmaquelle oder Gruppe von Plasmaquellen in Richtung einer optimalen Temperatur gesteuert werden.

Gemäß einer weiteren Ausführungsform der erfindungsgemäßen Inline-Beschichtungsanlage sind die unterschiedlichen Plasmaquellen einseitig und/oder beidseitig der Substrate in der Prozesskammer angeordnet. Durch eine beidseitige Anordnung von Plasmaquellen ist eine beidseitige Beschichtung von Substraten in der gleichen Prozesskammer möglich. Durch Verwendung unterschiedlicher Plasmaquellen für die Vorderseiten- und Rückseitenbeschichtung ist es zudem möglich, beide Seiten eines Substrates in der gleichen Prozesskammer unterschiedlich zu beschichten.

Bevorzugte Ausführungsformen der vorliegenden Erfindung, deren Aufbau, Funktion und Vorteile werden im Folgenden anhand der Figuren der Zeichnung näher erläutert, wobei
- Figur 1: eine schematische Übersichtsdarstellung einer Ausführungsform einer erfindungsgemäßen Inline-Beschichtungsanlage mit unterschiedlichen Prozesskammern zeigt;
- Figur 2: eine Skizze einer Ausführungsvariante einer Prozesskammer der erfindungsgemäßen Inline-Beschichtungsanlage mit vier Plasmaquellen mit unterschiedlichen Betriebsparametern zeigt;
- Figur 3: eine Skizze einer weiteren möglichen Prozesskammer der erfindungsgemäßen Inline-Beschichtungsanlage mit zwei unterschiedlichen Typen von Plasmaquellen zeigt;
- Figur 4: eine Skizze noch einer weiteren möglichen Prozesskammer der erfindungsgemäßen Inline-Beschichtungsanlage, bei der unterschiedliche Typen von Plasmaquellen und unterschiedliche Gasversorgungen für jeden Plasmaquellentyp eingesetzt werden, zeigt;
- Figur 5: schematisch eine weitere Variante einer Prozesskammer der erfindungsgemäßen Inline-Beschichtungsanlage zeigt, die mehrere Gasabsaugungen aufweist, die den unterschiedlichen Plasmaquellen zugeordnet sind;
- Figur 6: schematisch eine mögliche Prozesskammerausführung der erfindungsgemäßen Inline-Beschichtungsanlage zeigt, bei der die Plasmaquellen unter den Substraten angeordnet sind;
- Figur 7: eine schematische Darstellung eines weiteren Ausführungsbeispiels einer Prozesskammer der erfindungsgemäßen Inline-Beschichtungsanlage zeigt, bei der mehrere Plasmaquellen, die vom gleichen Typ sind, aber unterschiedliche Betriebsparameter aufweisen, auf beiden Seiten eines Substrates angeordnet sind;
- Figur 8: ein Ausführungsbeispiel einer Prozesskammer der erfindungsgemäßen Inline-Beschichtungsanlage zeigt, in der auf beiden Seiten des Substrates unterschiedliche Typen von Plasmaquellen angeordnet sind; und
- Figur 9: eine schematische Übersichtsdarstellung einer erfindungsgemäßen InlineBeschichtungsanlage mit beidseitig zum Substrat angeordneten Plasmaquellen zur zweiseitigen Beschichtung von Substraten zeigt.

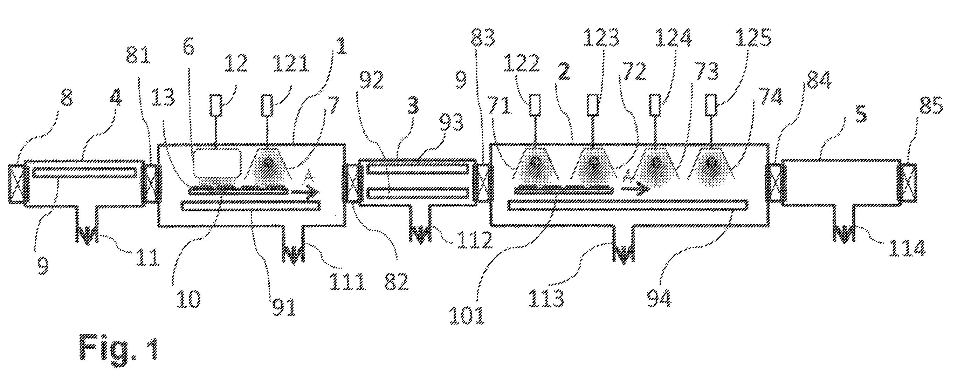

Fig. 1 zeigt schematisch den prinzipiellen Aufbau einer Ausführungsform der erfindungsgemäßen Inline-Beschichtungsanlage zur plasmagestützten chemischen Gasphasenabscheidung (PECVD) von Einzel- und/oder Gradientenschichten auf Substraten 13. Die Inline-Beschichtungsanlage weist in dem gezeigten Beispiel zwei Prozesskammern 1, 2 auf. Des Weiteren umfasst das dargestellte Beispiel eine Einschleusekammer 4, die in der Förderrichtung A der Substrate 13 durch die Prozesskammer 1 vor der ersten Prozesskammer 1 angeordnet ist, eine Trennkammer 3, die zwischen den beiden Prozesskammern 1, 2 angeordnet ist, und eine Ausschleusekammer 5, die nach der zweiten Prozesskammer 2 angeordnet ist. Die erfindungsgemäße Inline-Beschichtungsanlage ist nicht auf die dargestellte Ausführung festgelegt, sie kann vielmehr auch andere Beschichtungskammern, Konditionierungskammern, Ätzkammern oder sonstige Kammern aufweisen. Fig. 1 ist nur als schematische Darstellung zum Zweck der Erklärung zu verstehen. Verschiedene technische Details der Anlage, die zum Betrieb erforderlich sind, aber zum Stand der Technik gehören, sind der besseren Übersichtlichkeit halber nicht separat dargestellt und nachfolgend nicht extra erläutert.

Die einzelnen Kammern der erfindungsgemäßen Inline-Beschichtungsanlage sind Vakuumkammern, die in der Regel bei Vakuum oder Unterdruck betrieben werden. In der Inline-Beschichtungsanlage erfolgt ein Durchtransport von Substraten 13, die in den Prozesskammern 1, 2 prozessiert werden. In Transportrichtung der Substrate 13 werden die Kammern durch Vakuumventile 8, 81 82, 83, 84, 95 begrenzt. Die Vakuumventile können beispielsweise mechanische Ventile sein, es können jedoch auch andere im Stand der Technik bekannte Lösungen zur Vakuumabtrennung verwendet werden. Jede Kammer besitzt wenigstens einen Saugstutzen 11, 111, 112, 113, 114 für den Anschluss von Vakuumpumpen.

Für den Substrattransport durch die Inline-Beschichtungsanlage wird ein Transportsystem verwendet, das Stand der Technik ist und der Einfachheit halber nicht dargestellt ist. Geeignete Transportsysteme sind zum Beispiel Rollentransportsysteme oder Transportsysteme mit Linearmotoren. Die Antriebe des Transportsystems können neben dem kontinuierlichen Transport auch einen diskontinuierlichen Transport der Substrate 13 ermöglichen. Die Transportrichtungen und -geschwindigkeiten können bei der vorliegenden Erfindung den technologischen Erfordernissen, aber auch den gewünschten Eigenschaften der herzustellenden Schichten oder Schichtfolgen angepasst werden. Neben der typischen linearen Bewegung kann bei der erfindungsgemäßen Inline-Beschichtungsanlage im Bereich der Oberflächenbearbeitung auch eine oszillierende bidirektionale Bewegung ausgeführt werden. Großflächige Substrate 13 können direkt von dem Transportsystem durch die Inline-Beschichtungsanlage bewegt werden. Zur Beschichtung von Substraten 13 mit kleinen Abmessungen können auch Substratträger 10, 101 verwendet werden, die eine Vielzahl von einzelnen Substraten 13 aufnehmen können. Des Weiteren kann das Transportsystem in einer bekannten Weise für einen Transport von zu beschichtenden Folien ausgebildet sein.

In wenigstens einer der Prozesskammern 1, 2 befinden sich erfindungsgemäß mindestens zwei unterschiedliche Plasmaquellen 6 und 7, die in Transportrichtung nacheinander angeordnet sind. Für die Plasmaquellen 6, 7 werden bevorzugt linear skalierbare Plasmaquellen eingesetzt. Es können aber auch sogenannte Punktquellen bzw. kreissymmetrische Plasmaquellen verwendet werden, wobei in diesem Fall mehrere solcher Plasmaquellen bevorzugt in einer Reihe zu je einer neuen linearen Anordnung zusammengefasst werden. Der Abstand der einzelnen Plasmaquellen ist dabei dann so klein gewählt, dass deren einzelne erzeugte Plasmen sich an der Oberfläche der Substrate 13 zu einem gemeinsamen linear erstreckten Plasma überlagern, wodurch eine den Erfordernissen gerecht werdende homogene Oberflächenbearbeitung erreicht werden kann. In der Abbildung sind die linearen Plasmaquellen 6, 7 in ihrem Querschnitt gezeigt. Die linear skalierbare Abmessung erstreckt sich aus der Bildebene heraus.

Die Prozesskammer 1 weist zwei Plasmaquellen 6, 7 unterschiedlichen Typs bzw. konstruktiv unterschiedliche Plasmaquellen 6, 7 auf, wobei die beiden Plasmaquellen 6, 7 hier nur beispielhaft dargestellt sind und auch mehr als zwei Plasmaquellen oder Gruppen von Plasmaquellen verwendet werden können. Insbesondere sind die beiden Plasmaquellen 6, 7 bei unterschiedlichen Frequenzen arbeitende Plasmaquellen. Die Plasmaquelle 6 ist eine RF-Plasmaquelle oder eine ICP-Plasmaquelle, die mit elektrischer Leistung relativ niedriger Frequenz versorgt wird, wobei unter niedrigen Frequenzen ein Bereich von Gleichstrom bis 100 MHz zu verstehen ist. Vorzugsweise verwendet die Plasmaquelle 6 eine zugelassene Frequenz in dem Bereich von 50 kHz bis 13,56 MHz. Die Plasmaquelle 7 ist in dem gezeigten Beispiel eine Mikrowellenplasmaquelle und arbeitet mit Frequenzen zwischen 100 MHz und mehreren GHz, wobei besonders bevorzugte Frequenzen 915 MHz oder 2,45 GHz sind.

Die unterschiedlichen Plasmaquellen in einer Prozesskammer der erfindungsgemäßen Inline-Beschichtungsanlage können sich, wie oben erwähnt, konstruktiv, das heißt hinsichtlich ihres Typs, wie in der Prozesskammer 1, unterscheiden. Es können jedoch auch funktionelle Unterschiede zwischen den Plasmaquellen bzw. Unterschiede im Hinblick auf die Betriebsart oder Betriebsbedingungen bei ansonsten gleichem Aufbau der Plasmaquellen vorliegen, wie es anhand der Prozesskammer 2 skizziert ist. Diese Prozesskammer 2 verwendet vier Plasmaquellen 71, 72, 73, 74 gleicher Bauart, die jedoch unterschiedliche Betriebsparameter aufweisen.

Zu den elektrischen Betriebsparametern zählen die eingesetzte Plasmafrequenz, die im Plasma umgesetzte effektive elektrische Leistung sowie im Falle einer gepulsten elektrischen Versorgung der Plasmaquellen die Pulsparameter, wie zum Beispiel die Puls-Spitzenleistung, die Puls-An-Zeit und die Puls-Aus-Zeit, die Synchronisation der Plasmaquellen, die Phasengleichheit oder der Phasenversatz. Mit Hilfe solcher Parameter besteht die Möglichkeit, Einfluss auf die entstehenden Gasfragmente im Plasma zu nehmen, die Zusammensetzung des Plasmas zu steuern und die Konzentration von Gasfragmenten zu beeinflussen. Des Weiteren kann mit den elektrischen Betriebsbedingungen der eingesetzten Plasmaquellen Einfluss auf die Wechselwirkung des Plasmas mit der Substratoberfläche genommen werden. Die unterschiedlichen elektrischen Betriebsbedingungen führen dazu, dass die Plasmaquellen, neben den oben erwähnten, sich schon konstruktiv unterscheidenden Plasmaquellen, unterschiedliche Plasmaquellen im Sinne der vorliegenden Erfindung sind. Sie können dadurch insgesamt einen großen Einfluss auf die Schichtzusammensetzung und die speziellen Schichtwachstumsprozesse der dünnen Schichten und damit auch auf die Eigenschaften der hergestellten Schichten haben.

Jede der einzelnen Plasmaquellen 6, 7, 71, 72, 73, 74 der erfindungsgemäßen Inline-Beschichtungsanlage besitzt mindestens einen Gasanschluss 12, 121, 122, 123, 124, 125 zur Zufuhr von Prozessgasen. Innerhalb jeder Plasmaquelle kann wenigstens eine Gasdusche, die nicht dargestellt ist, der Gasverteilung dienen. Für jede der Plasmaquellen 6, 7, 71, 72, 73, 74 können die Gaszuflüsse sowie die elektrischen Betriebsbedingungen der Plasmaquellen 6, 7, 71, 72, 73, 74 separat eingestellt oder geregelt werden.

Die einzelnen Kammern der erfindungsgemäßen Inline-Plasmabeschichtungsanlage können optional mit Heiz- und/oder Kühlvorrichtungen 9, 91, 92, 93, 94 ausgestattet sein. Die Heiz- und/oder Kühlvorrichtungen dienen der Temperierung auf Temperaturen von typischerweise 20°C bis 600°C der Substratträger 10, 101 bzw. der Substrate 13.

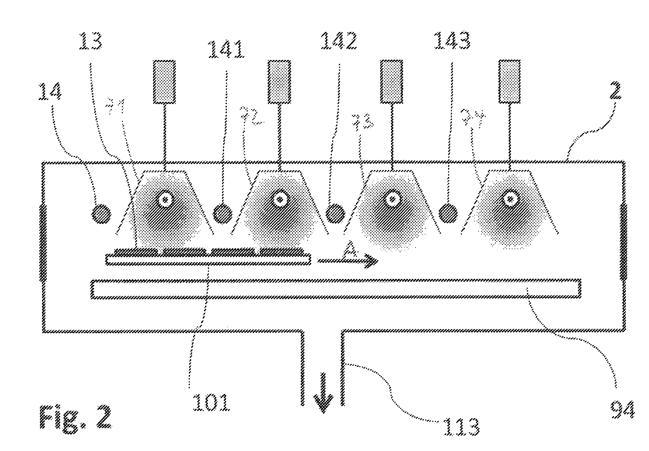

Fig. 2 zeigt die Prozesskammer 2 aus Fig. 1 in einer vergrößerten und detaillierteren Darstellung. Zusätzlich zu den in Fig. 1 gezeigten Elementen sind hier neben den Plasmaquellen 71, 72, 73, 74 Gasduschen 14, 141, 142, 143 gezeigt, die zusätzlich zur Zuführung von Prozessgasen in die Prozesskammer 2 verwendet werden können. Auf dem Substratträger 101 befinden sich Substrate 13, die entsprechend der durch den Pfeil A gekennzeichneten Durchlaufrichtung durch die Inline-Beschichtungsanlage von dem oben beschriebenen Transportsystem durch die Anlage transportiert, nacheinander unter den Plasmaquellen 71, 72, 73, 74 hindurchgeführt und kontinuierlich beschichtet werden.

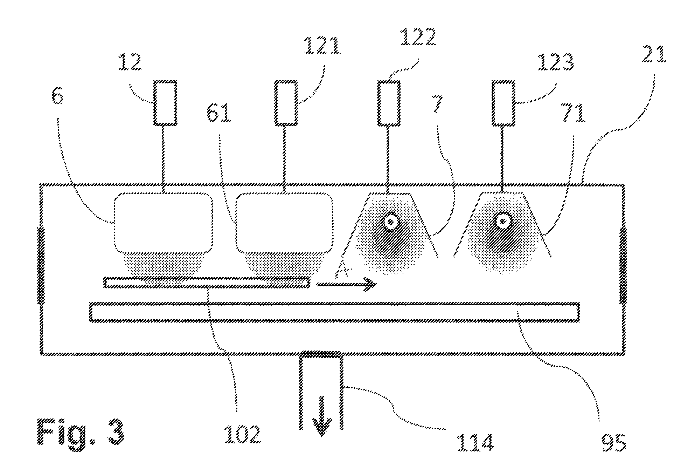

Fig. 3 zeigt eine Prozesskammer 21 gemäß einer weiteren möglichen Variante der efindungsgemäßen Inline-Beschichtungsanlage, bei der anhand von zwei Plasmaquellen 6, 61 und zwei Plasmaquellen 7, 71 schematisch dargestellt ist, dass die Anzahl der eingesetzten Plasmaquellen variiert bzw. erhöht werden kann. Die Anzahl und die Anordnung der gleichen Plasmaquellen untereinander wird in Abhängigkeit von dem Gesamtschichtstapeldesign der auf den Substraten 13 auszubildenden Mehrlagenanordnung festgelegt.

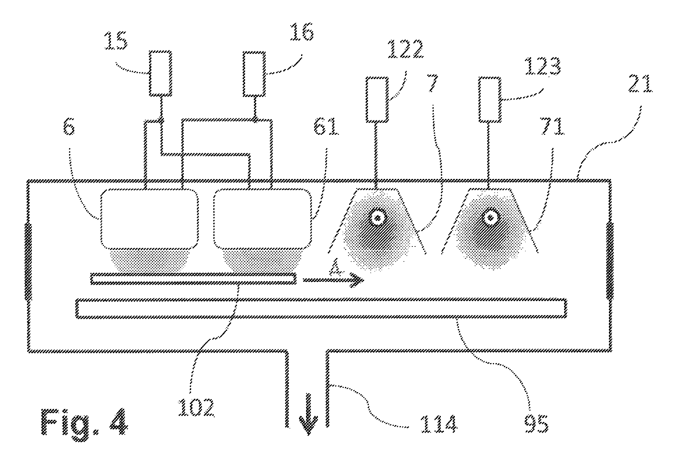

Fig. 4 zeigt eine mögliche Vereinfachung der Prozesskammer 21 aus Fig. 3. Dabei sind hier Plasmaquellen 6, 61 bzw. 7, 71, die gleich betrieben werden, zu Gruppen zusammengefasst, die über gemeinsame Gasversorgungen 15 und 16 verfügen. Durch die Zusammenfassung zu Gruppen kann der Aufwand zur Herstellung der erfindungsgemäßen Anlagen reduziert werden.

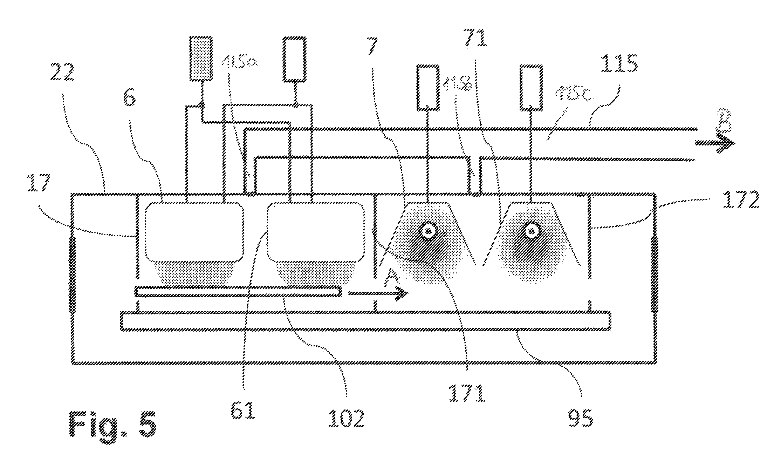

Fig. 5 zeigt eine vorteilhafte Weiterbildung einer Prozesskammer 22 der erfindungsgemäßen Inline-Beschichtungsanlage. Die Prozesskammer 22 weist jeweils zwei Plasmaquellen 6, 61 und 7, 71 unterschiedlichen Typs auf, die paarweise angeordnet sind und gruppenweise betrieben werden. Die Bearbeitungsgebiete der Plasmaquellengruppen werden in dieser vorteilhaften Weiterbildung durch Leitwertblenden 17, 171, 172 voneinander abgegrenzt. Die Abgrenzung der beiden Bearbeitungsbereiche wird in dem gezeigten Beispiel zusätzlich durch eine separate Gasabsaugung 115a, 115b für jeden Bearbeitungsbereich im oberen Bereich der Prozesskammer 22 erreicht. Die Gasabsaugung 115 kann in einer vorteilhaften Ausführung so ausgebildet sein, dass sie einen separaten Raum 115 c bildet, in welchen ein entstehender Abgasstrom beidseitig an jeder einzelnen der Plasmaquellen 6, 61, 7, 71 absaugbar ist. In dem separaten Raum 115c erfolgt auch bei hohen Gasdurchflüssen ein guter Druckausgleich, wodurch eine gleichmäßige Gasabsaugung und in der Folge gute Schichthomogenitäten erreicht werden. Des Weiteren ist in Fig. 5 ein Substrat 102 gezeigt, das gemäß der Richtung des Pfeils A durch die Prozesskammer 22 unter den Plasmaquellen 6, 61, 7, 71 hindurchbewegt wird. Dabei kann das Substrat 102 oder ein Substratträger durch eine Heiz- und/oder Kühlvorrichtung 95 lokal unterschiedlich beheizt und/oder gekühlt werden.

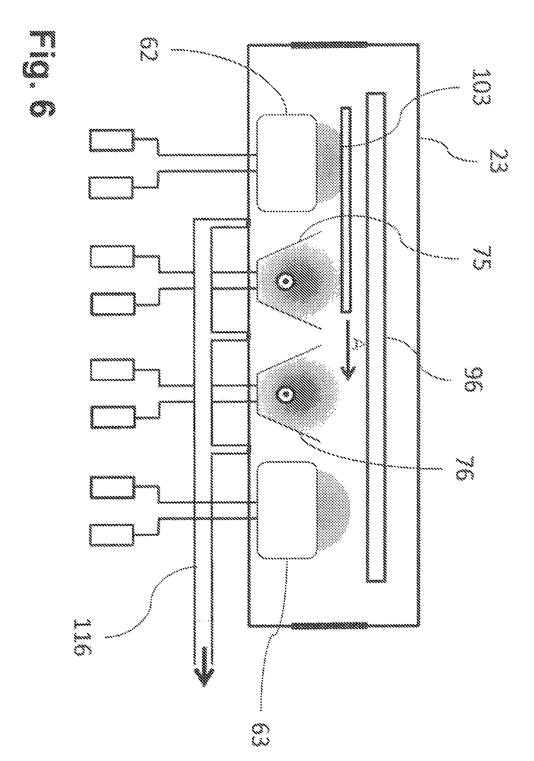

Fig. 6 zeigt eine alternative Ausführungsvariante einer Prozesskammer 23 der erfindungsgemäßen Inline-Beschichtungsanlage, in der Plasmaquellen 62, 75, 76, 63 anders als in den oben beschriebenen Ausführungsbeispielen auf einer zweiten Seite bzw. der Rückseite eines Substrats 103, also in der Beispieldarstellung unter dem Substrat 103, angeordnet sind. In anderen, nicht dargestellten Prozesskammern sind die Substrate senkrecht ausgerichtet und die Plasmaquellen befinden sich links und rechts der Substrate. Das dargestellte Ausführungsbeispiel weist Plasmaquellen 62, 63 eines Typs und Plasmaquellen 75, 76 eines anderen Typs auf. Zudem ist oberhalb des Substrates 103 bzw. oberhalb von den die Prozesskammer 23 durchlaufenden Substraten eine Heiz- und/oder Kühlvorrichtung 96 zum Heizen und/oder Kühlen der Substrate und/oder Substratträger vorgesehen.

Fig. 6 zeigt beispielhaft, dass die Reihenfolge der Anordnung der einzelnen Plasmaquellentypen erfindungsgemäß beliebig ist und dass die in den Figuren gezeigten Ausführungsbeispiele abgewandelt werden können, um den gewünschten auszubildenden Schichtstapeln Rechnung zu tragen. In dem in Fig. 6 dargestellten Ausführungsbeispiel erfolgt zuerst eine ionenunterstützte Abscheidung, im zweiten Schritt eine Abscheidung mit geringer lonenunterstützung und im dritten Schritt eine zweite Abscheidung mit hoher lonenunterstützung.

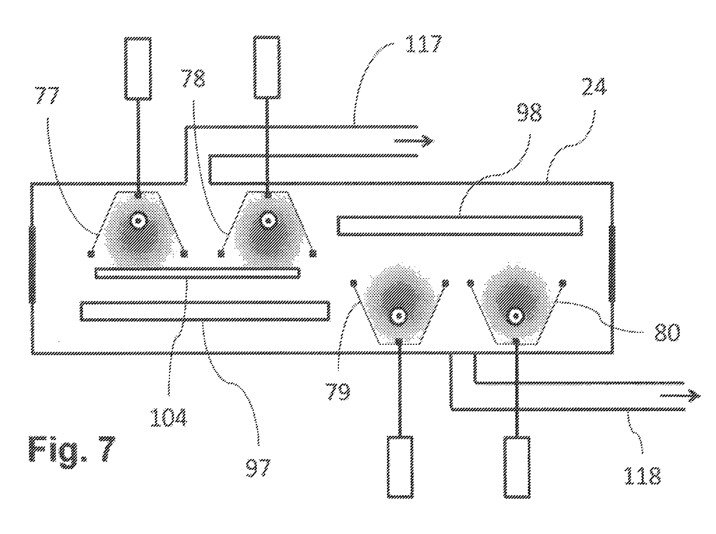

Fig. 7 zeigt eine vorteilhafte Weiterbildung einer weiteren möglichen Prozesskammer 16 der erfindungsgemäßen Inline-Beschichtungsanlage, bei der zwei gleiche Plasmaquellen 77, 78 und eine Gasabsaugung 117 auf einer ersten Substratseite angeordnet sind, wobei eine Heiz- und/oder Kühlvorrichtung 97 das Substrat 104 während der Bearbeitung mit den Plasmaquellen 77, 78 von der zweiten Substratseite her heizt. Desweiteren weist die Prozesskammer 26 in dem Ausführungsbeispiel zwei Plasmaquellen 79, 80, die sich konstruktiv oder hinsichtlich ihrer Betriebsparameter von den Plasmaquellen 77, 78 unterscheiden, eine Gasabsaugung 118 auf der zweiten Substratseite und gegenüber eine Heiz- und/oder Kühlvorrichtung 98 für die Substrate auf der ersten Substratseite auf.

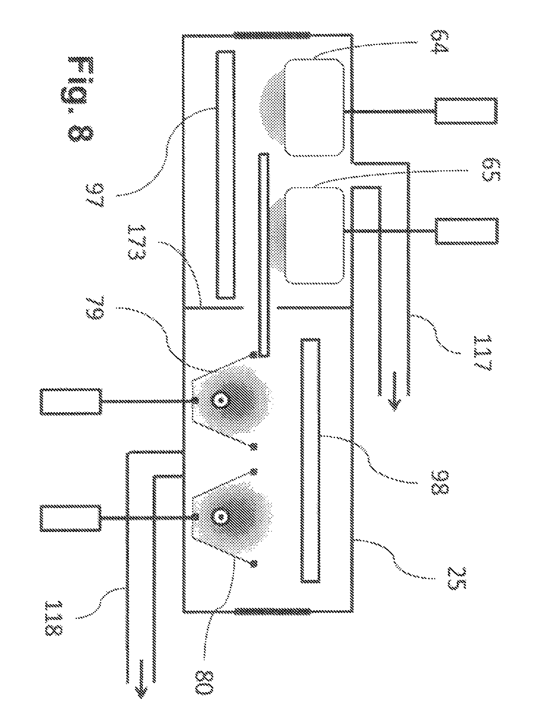

Fig. 8 zeigt eine weitere mögliche Ausführungsform einer Prozesskammer 25 der erfindungsgemäßen Inline-Beschichtungsanlage. Die Prozesskammer 25 weist einen ersten Beschichtungsbereich mit Plasmaquellen 64, 65 eines Typs und einer Gasabsaugung 117 und einer gegenüberliegenden Heiz- und/oder Kühlvorrichtung 97 zur Beschichtung einer ersten Substratseite und einen zweiten Beschichtungsbereich auf, der durch eine Leitwertblende 173 von dem ersten Beschichtungsbereich getrennt ist und der Plasmaquellen 79, 80 eines zweiten Typs zur Beschichtung einer zweiten Substratseite, eine Gasabsaugung 118 und eine gegenüberliegende Heiz- und/oder Kühlvorrichtung 98 aufweist.

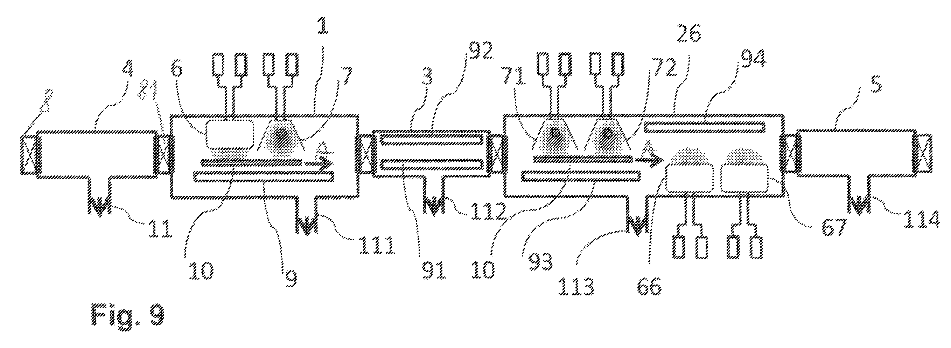

Fig. 9 skizziert übersichtsweise eine erfindungsgemäße Inline-Beschichtungsanlage mit zwei Prozesskammern 1, 26, die zur zweiseitigen Bearbeitung von Substraten ausgebildet ist. Dabei bezeichnen gleiche Bezugszeichen, die oben bereits im Hinblick auf die Fig. 1 bis 8 verwendet wurden, gleiche bzw. ähnliche Elemente, zu welchen auf obige Beschreibung verwiesen wird. Fig. 9 zeigt überblicksweise noch einmal Elemente der erfindungsgemäßen Inline-Beschichtungsanlage in anderen als den oben beschriebenen Kombinationen, wobei verschiedene Typen von Plasmaquellen bzw. Plasmaquellen mit unterschiedlichen konstruktiven und/oder funktionellen Eigenschaften bzw. Betriebsparametern 6, 7, 71, 72, 66, 67 in wenigstens einer Prozesskammer 1, 26 angeordnet sind und wobei die Einbaulage der Plasmaquellen auf beiden Seiten eines flächigen Substrates liegen kann. Die erfindungsgemäße Inline-Plasmabearbeitungsanlage umfasst des Weiteren Heiz- und/oder Kühlvorrichtungen 9, 91, 92, 93, 94 in den Prozesskammern und anderen Kammern.

Im Folgenden wird anhand von Fig. 9 die Funktionsweise der erfindungsgemäßen Inline-Beschichtungsanlage beispielhaft erläutert.

Zuerst werden die Substrate oder die Substratträger mit Substraten durch ein geöffnetes erstes Vakuumventil 8 in eine Einschleusekammer 4 transportiert. Zum Substrattransport wird ein Transportsystem verwendet, das hier nicht dargestellt ist. Der Transport erfolgt in der gezeigten Darstellung in der mit dem Pfeil A gekennzeichneten Förderrichtung. Grundsätzlich ist es jedoch auch möglich, dass der Transport der Substrate, wie oben bereits erwähnt, auch zumindest teilweise gegenläufig zu der Transportrichtung A oder oszillierend erfolgt. Wenn das wenigstens eine Substrat vollständig in die Einschleusekammer 4 transportiert wurde, wird das Vakuumventil 8 zur Atmosphäre geschlossen und die Einschleusekammer 4 wird über einen Saugstutzen 11, an dem eine hier nicht dargestellte Vakuumpumpe angeschlossen ist, evakuiert.

Anschließend wird ein Vakuumventil 8 zu einer ersten Prozesskammer 1 geöffnet und das Substrat in Transportrichtung A durch die erste Prozesskammer 1 bewegt. Dabei erfolgt eine Substratbeheizung durch eine Heiz- und/oder Kühlvorrichtung, die Herstellung einer ersten Schicht mittels einer über den Substraten angeordneten Plasmaquelle 6 und nachfolgend die Herstellung einer zweiten Schicht mit einer über den Substraten und in Substratdurchlaufrichtung nach der ersten Plasmaquelle 6 angeordneten, sich von der ersten Plasmaquelle 6 unterscheidenden zweiten Plasmaquelle 7.

Bei der Beschichtung von Siliziumsolarzellen kann die Plasmaquelle 6 beispielsweise eine etwa 10 nm dicke siliziumreiche Siliziumnitridschicht mit einem hohen Wasserstoffanteil und einer geringen Dichte, bei welcher diese Schicht durchlässig für Wasserstoff ist, herstellen. Die zweite Plasmaquelle 7 kann daraufhin unmittelbar anschließend in der gleichen Prozesskammer eine zweite Siliziumnitridschicht, die etwa drei- bis viermal so dick wie die erste Siliziumnitridschicht ist, erzeugen. Die zweite Siliziumnitridschicht ist eine etwa stöchiometrische Si₃N₄-Schicht mit geringen optischen Verlusten und einem hohen Wasserstoffanteil, der als Wasserstoffquelle für die Volumenpassivierung des Halbleiters dient.

Nach der zweiten Beschichtung durch die Plasmaquelle 7 erfolgt ein Weitertransport in eine Trennkammer 3, die Heizelemente 91, 92 aufweist. In dem gezeigten Beispiel werden die Heizelemente 91, 92 dazu verwendet, das Substrat bzw. die Substrate zu erwärmen, den Wasserstoff aus der zweiten Siliziumnitridschicht in das Halbleitermaterial eindiffundieren zu lassen und die bisher erfolgte Beschichtung zu verdichten.

Eine nächste Prozessierung der Substrate in der Inline-Beschichtungsanlage erfolgt in der Prozesskammer 26. Hier wird zunächst eine Substratvorderseite mithilfe von Plasmaquellen 71, 72 mit einer weiteren Schicht beschichtet, wobei die Substrate durch eine Heiz- und/oder Kühlvorrichtung 93 beheizt werden. Die weitere Schicht kann beispielsweise eine Titandioxidschicht sein, die zur Vollendung einer Antireflexionsbeschichtung benötigt wird. Im Anschluss an diese weite Vorderseitenbeschichtung erfolgt ein Weitertransport der Substrate zu Plasmaquellen 66, 67 und einer Heiz- und/oder Kühlvorrichtung 94, wo eine Rückseitenbeschichtung der Substrate, beispielsweise zum Erzeugen einer Reflexionsschicht, erfolgt. Abschließend erfolgt ein Transport der Substrate in eine Ausschleusekammer 5, wo die Substrate abschließend gespült und giftige Reaktionsendprodukte abgepumpt werden und wo eine Belüftung erfolgt, bevor die Substrate zurück in die Atmosphäre transportiert werden.

## Patentansprüche

1. Inline-Beschichtungsanlage zur plasmagestützten chemischen Gasphasenabscheidung, die wenigstens eine Prozesskammer (1, 2) mit wenigstens zwei nacheinander in Förderrichtung von Substraten (13) durch die Prozesskammer (1, 2) angeordneten Plasmaquellen aufweist, wobei die wenigstens zwei Plasmaquellen unterschiedliche Plasmaquellen (6, 7) sind, die wenigstens zwei Plasmaquellen (6, 7) bei unterschiedlichen Anregungsfrequenzen arbeitende Plasmaquellen sind, und wobei die wenigstens zwei Plasmaquellen (6, 7) wenigstens eine erste, in einem Bereich von Gleichstrom bis 100 MHz arbeitende Plasmaquelle (6) und wenigstens eine zweite, in einem Bereich von 100 MHz bis mehreren GHz arbeitende Plasmaquelle (7) aufweisen, **dadurch gekennzeichnet, dass** die wenigstens eine erste Plasmaquelle (6) eine RF-Plasmaquelle oder eine ICP-Plasmaquelle Ist und die wenigstens eine zweite Plasmaquelle (7) eine Mikrowellen-Plasmaquelle ist.

2. Inline-Beschichtungsanlage nach Anspruch 1, **dadurch gekennzeichnet, dass** wenigstens eine der wenigstens zwei Plasmaquellen (6, 7) eine mit gepulster Anregungsfrequenz betriebene Plasmaquelle ist.

3. Inline-Beschichtungsanlage nach einem der vorhergehenden Ansprüche, **dadurch gekennzeichnet, dass** die erste Plasmaquelle (6) eine in einem Bereich von 50 KHz bis 13,56 MHz arbeitende Plasmaquelle ist und die zweite Plasmaquelle (7) eine in einem Bereich von 915 MHz bis 2,45 GHz arbeitende Plasmaquelle ist.

4. Inline-Beschichtungsanlage nach einem der vorhergehenden Ansprüche, **dadurch gekennzeichnet, dass** die wenigstens eine erste Plasmaquelle (6) in der Förderrichtung der Substrate (13) durch die Prozesskammer (1, 2) vor der wenigstens einen zweiten Plasmaquelle (7) angeordnet ist.

5. Inline-Beschichtungsanlage nach einem der vorhergehenden Ansprüche, **dadurch gekennzeichnet, dass** die wenigstens zwei Plasmaquellen (6, 7) linear skalierbare Plasmaquellen aufweisen.

6. Inline-Beschichtungsanlage nach einem der vorhergehenden Ansprüche, **dadurch gekennzeichnet, dass** die wenigstens zwei Plasmaquellen (6, 7) Punktquellen oder kreissymetrische Quellen sind, die in einer linearen Anordnung zusammengefasst sind, wobei der Abstand zwischen diesen Plasmaquellen so gewählt ist, dass sich deren einzelne Plasmen an den Oberflächen der Substrate (13) zu einem gemeinsamen Plasma überlagern.

7. Inline-Beschichtungsanlage nach einem der vorhergehenden Ansprüche, **dadurch gekennzeichnet, dass** wenigstens zwei der Plasmaquellen (6, 7) zu wenigstens einer Gruppe zusammengefasst sind.

8. Inline-Plasmabeschichtungsanlage nach einem der vorhergehenden Ansprüche, **dadurch gekennzeichnet, dass** die wenigstens zwei Plasmaquellen (6, 7) separate Gasversorgungen aufweisen.

9. Inline-Beschichtungsanlage nach einem der vorhergehenden Ansprüche, **dadurch gekennzeichnet, dass** jede der wenigstens zwei Plasmaquellen (6, 7) und/oder Gruppen von Plasmaquellen eine separate Gasabsaugung aufweist.

10. Inline-Beschichtungsanlage nach Anspruch 9, **dadurch gekennzeichnet, dass** die separate Gasabsaugung einen Raum aufweist, in welchen ein entstehender Abgasstrom beidseitig an jeder einzelnen der Plasmaquellen absaugbar ist.

11. Inline-Beschichtungsanlage nach einem der vorhergehenden Ansprüche, **dadurch gekennzeichnet, dass** zwischen den einzelnen Plasmaquellen (6, 7) und/oder Gruppen von Plasmaquellen Leitwertblenden angeordnet sind.

12. Inline-Beschichtungsanlage nach einem der vorhergehenden Ansprüche, **dadurch gekennzeichnet, dass** die Inline-Beschichtungsanlage ein Transportsystem für die Substrate (13) mit wenigstens einem Steuermodul für die Transportgeschwindigkeit und/oder die Transportrichtung der Substrate (13) aufweist.

13. Inline-Beschichtungsanlagen nach einem der vorhergehenden Ansprüche, **dadurch gekennzeichnet, dass** die Inline-Beschichtungsanlage wenigstens eine Heiz- und/oder Kühlvorrichtung (95, 96) aufweist, mit welcher die Substrate (13) und/oder Substratträger (10, 101) in Abhängigkeit von ihrer Position in der Inline-Beschichtungsanlage verschieden beheiz- und/oder kühibar sind.

14. Inline-Beschichtungsanlage nach wenigstens einem der vorhergehenden Ansprüche, **dadurch gekennzeichnet, dass** die unterschiedlichen Plasmaquellen einseitig- und/oder beidseitig der Substrate (13) in der Prozesskammer (1, 2) angeordnet sind.

## Claims

1. Inline coating device for plasma enhanced chemical vapour deposition, comprising at least one process chamber (1, 2) with at least two plasma sources arranged successively in conveying direction of substrates (13) through the process chamber (1, 2), wherein the at least two plasma sources are different plasma sources (6, 7), the at least two plasma sources (6, 7) are two plasma sources operating at different excitation frequencies, and wherein the at least two plasma sources (6, 7) have at least one first plasma source (6) operating in a range of direct current up to 100 MHz and at least one second plasma source (7) operating in a range from 100 MHz to several GHz, **characterized in that** the at least one first plasma source (6) is a RF plasma source or a ICP plasma source and the at least one second plasma source (7) is a microwave plasma source.

2. Inline coating device according to claim 1, **characterized in that** at least one of the at least two plasma sources (6, 7) is a plasma source operated with a pulsed excitation frequency.

3. Inline coating device according to one of the preceding claims, **characterized in that** the first plasma source (6) is a plasma source operating in a range of 50 kHz to 13.56 MHz and the second plasma source (7) is a plasma source operating in a range of 915 MHz to 2.45 GHz.

4. Inline coating device according to one of the preceding claims, **characterized in that** the at least one first plasma source (6) is arranged upstream of the at least one second plasma source (7) in the conveying direction of substrates (13) through the process chamber (1, 2).

5. Inline coating device according to one of the preceding claims, **characterized in that** the at least two plasma sources (6, 7) comprise linearly scalable plasma sources.

6. Inline coating device according to one of the preceding claims, **characterized in that** the at least two plasma sources (6, 7) are point sources or circle-symmetric sources which are combined in a linear arrangement, wherein the distance between said plasma sources is chose such that the individual plasmas thereof are superimposed at the surfaces of the substrates (13) to form a common plasma.

7. Inline coating device according to one of the preceding claims, **characterized in that** at least two of said plasma sources (6, 7) are combined to form at least one group.

8. Inline coating device according to one of the preceding claims, **characterized in that** that the at least two plasma sources (6, 7) have separate gas supplies.

9. Inline coating device according to one of the preceding claims, **characterized in that** each of the at least two plasma sources (6, 7) and/or groups of plasma sources has a separate gas extraction.

10. Inline coating device according to claim 9, **characterized in that** the separate gas extraction has a space into which an resulting exhaust gas flow is extractable on both sides at each individual one of the plasma sources.

11. Inline coating device according to one of the preceding claims, **characterized in that** conductance screens are arranged between the individual plasma sources (6, 7) and/or groups of plasma sources.

12. Inline coating device according to one of the preceding claims, **characterized in that** the inline coating device comprises a transport system for the substrates (13) with at least one control module for the transport speed and/or the transport direction of the substrates (13).

13. Inline coating device according to one of the preceding claims, **characterized in that** the inline coating device comprises at least one heating and/or cooling device (95, 96) by which the substrates (13) and/or substrate carriers (10, 101) can be heated and/or cooled differently depending on their position in the inline coating device.

14. Inline coating device according to at least one of the preceding claims, **characterized in that** the different plasma sources are arranged on one side and/or on both sides of the substrates (13) in the process chamber (1, 2).

## Revendications

1. Installation de revêtement en ligne destinée au dépôt chimique en phase vapeur assisté par plasma qui présente au moins une chambre de traitement (1, 2) avec au moins deux sources de plasma qui se suivent dans la direction de déplacement de substrats (13) à travers la chambre de traitement (1, 2), dans laquelle installation les au moins deux sources de plasma sont des sources de plasma (6, 7) différentes, les au moins deux sources de plasma (6, 7) sont des sources de plasma travaillant à différentes fréquences d'excitation, et dans laquelle installation les au moins deux sources de plasma (6, 7) présentent au moins une première source de plasma (6) travaillant dans une plage allant du courant continu jusqu'à 100 MHz et au moins une deuxième source de plasma (7) travaillant dans une plage de 100 MHz jusqu'à plusieurs GHz, **caractérisée en ce que** la première source de plasma (6) au moins au nombre de un est une source de plasma RF ou une source de plasma ICP, et la deuxième source de plasma (7) au moins au nombre de un est une source de plasma micro-onde.

2. Installation de revêtement en ligne selon la revendication 1, **caractérisée en ce qu**'au moins une des au moins deux sources de plasma (6, 7) est une source de plasma opérant avec une fréquence d'excitation pulsée.

3. Installation de revêtement en ligne selon l'une des revendications précédentes, **caractérisée en ce que** la première source de plasma (6) est une source de plasma travaillant dans une plage de 50 kHz à 13,56 MHz et la deuxième source de plasma (7) est une source de plasma travaillant dans une plage de 915 MHz à 2,45 GHz.

4. Installation de revêtement en ligne selon l'une des revendications précédentes, **caractérisée en ce que** la première source de plasma (6) au moins au nombre de un est, dans la direction de déplacement des substrats (13) à travers la chambre de traitement (1, 2), disposée en amont de la deuxième source de plasma (7) au moins au nombre de un.

5. Installation de revêtement en ligne selon l'une des revendications précédentes, **caractérisée en ce que** les au moins deux sources de plasma (6, 7) présentent des sources de plasma modulables de façon linéaire.

6. Installation de revêtement en ligne selon l'une des revendications précédentes, **caractérisée en ce que** les au moins deux sources de plasma (6, 7) sont des sources ponctuelles ou à symétrie circulaire qui sont réunies en un agencement linéaire, dans laquelle installation la distance entre ces sources de plasma est choisie de telle sorte que leurs plasmas individuels se superposent sur les surfaces des substrats (13) pour donner un plasma commun.

7. Installation de revêtement en ligne selon l'une des revendications précédentes, **caractérisée en ce qu**'au moins deux des sources de plasma (6, 7) sont réunies en au moins un groupe.

8. Installation de revêtement en ligne selon l'une des revendications précédentes, **caractérisée en ce que** les au moins deux sources de plasma (6, 7) présentent des alimentations en gaz séparées.

9. Installation de revêtement en ligne selon l'une des revendications précédentes, **caractérisée en ce que** chacune des au moins deux sources de plasma (6, 7) et/ou chacun des groupes de sources de plasma présente une aspiration de gaz séparée.

10. Installation de revêtement en ligne selon la revendication 9, **caractérisée en ce que** l'aspiration de gaz séparée présent un espace dans lequel un flux de gaz d'évacuation qui est présent peut être aspiré des deux côtés sur chaque source individuelle des sources de plasma.

11. Installation de revêtement en ligne selon l'une des revendications précédentes, **caractérisée en ce que** des diaphragmes de conductance sont disposés entre les différentes sources de plasma (6, 7) et/ou groupes de sources de plasma.

12. Installation de revêtement en ligne selon l'une des revendications précédentes, **caractérisée en ce que** l'installation de revêtement en ligne présente un système de transport pour les substrats (13) avec au moins un module de commande pour la vitesse de transport et/ou la direction de transport des substrats (13).

13. Installation de revêtement en ligne selon au moins l'une des revendications précédentes, **caractérisée en ce que** l'installation de revêtement en ligne présente au moins un dispositif de chauffage et/ou de refroidissement (95, 96) avec lequel les substrats (13) et/ou les supports de substrats (10, 101) peuvent être chauffés et/ou refroidis différemment en fonction de leur position dans l'installation de revêtement en ligne.

14. Installation de revêtement en ligne selon l'une des revendications précédentes, **caractérisée en ce que** les différentes sources de plasma sont disposées d'un côté et/ou des deux côtés des substrats (13) dans la chambre de de traitement (1, 2).
